# EUROPÄISCHE PATENTSCHRIFT

(11) **EP 1 252 663 B1**
(45) Veröffentlichungstag und Bekanntmachung des Hinweises auf die Patenterteilung: **05.03.2008**
(21) Anmeldenummer: 01907351.9
(22) Anmeldetag: 13.01.2001
(51) Int. Cl.: H01L 41/053

(54) **PIEZOAKTOR**
PIEZO ACTUATOR
ACTIONNEUR PIEZOELECTRIQUE

(30) Priorität: 21.01.2000 DE 10002437
(43) Veröffentlichungstag der Anmeldung: 30.10.2002
(73) Patentinhaber: ROBERT BOSCH GMBH, 70442 Stuttgart (DE)
(72) Erfinder: JUPE, Michael, 71636 Ludwigsburg (DE); SCHMOLL, Klaus-Peter, 74251 Lehrensteinsfeld (DE)
(86) Internationale Anmeldenummer: PCT/DE2001/000126
(87) Internationale Veröffentlichungsnummer: WO 2001/054207

(56) Entgegenhaltungen:
- EP-A- 0 147 534
- DE-A- 19 650 900
- US-A- 5 094 430
- US-A- 5 113 108
- PATENT ABSTRACTS OF JAPAN vol. 009, no. 139 (M-387), 14. Juni 1985 (1985-06-14) & JP 60 019968 A (NIPPON SOKEN INC), 1. Februar 1985 (1985-02-01) -& JP 60 019968 A (NIPPON SOKEN INC) 1. Februar 1985 (1985-02-01)

## Beschreibung

### Stand der Technik

Die Erfindung betrifft einen Piezoaktor, insbesondere zur Betätigung eines mechanischen Bauteils, beispielsweise für einen Einspritzinjektor zur Kraftstoffzumessung in einem Verbrennungsmotor, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt.

Für sich gesehen ist es auch bekannt, dass Einspritzdüsen oder -ventile zur Kraftstoffzumessung eines Verbrennungsmotors Druck- oder Steuerbolzen aufweisen, die hohe Drücke und schnelle und genaue Reaktionszeiten verlangen. Eins solche Einspritzvorrichtung ist beispielsweise in "Kraftfahrtechnisches Taschenbuch", VDI-Verlag 1987, 20. Auflage, Seiten 391,392 beschrieben. Bei dieser bekannten Anordnung wird der Piezoaktor zum Öffnen und Schließen der Nadel in der Einspritzdüse verwendet, wobei die Montage des gesamten Systems recht aufwendig ist und eine hohe Genauigkeit erfordert.

Ein Piezoaktor mit Zentrier- und Spannvorrichtung ist aus JP-A-60 19968 bekannt. US 5 094 430 offenbart einen Piezoaktor, bei dem eine Zentriervorrichtung direkt in die Keramik des Piezoelements eingreift.

Eine besondere Schwierigkeit besteht bei der bekannten Anordnung darin, den Piezoaktor zentriert zu einem Kopf- und zu einem Fußstück mittig auszurichten und diese Teile so zusammenhalten, dass sie sich beim anschließenden Vergießen und Einbauen der Teile nicht voneinander lösen. Üblicherweise erfolgt der Zusammenbau der Teile hier durch ein Klebeverfahren, wobei eine Zentrierung bei der Montage in der Regel nach Augenschein erfolgt.

### Vorteile der Erfindung

Der Gegenstand der Erfindung wird durch die Patentansprüche definiert. Der eingangs beschriebene Piezoaktor zur Betätigung eines mechanischen Bauteils, beispielsweise für einen Einspritzinjektor zur Kraftstoffzumessung in einem Verbrennungsmotor, weist in vorteilhafter Weise ein Kopf- und ein Fußteil auf, zwischen dem ein Piezoelement in Betätigungsrichtung eingespannt ist. Es ist hier mindestens ein Zentrierkörper vorhanden, der zwischen dem Piezoelement und dem Kopf- und/oder dem Fußteil liegt. Weiterhin ist eine Spannanordnung vorhanden, die zwischen dem Kopf- und dem Fußteil zur Einspannung des Piezoelements angeordnet ist.

Es ist mit der erfindungsgemäßen Anordnung auf einfache Weise erreicht, dass der gesamte Piezoaktor mit Kopf- und Fußteil zentriert ist, wodurch eine einseitige mechanische Belastung des Piezoelements und damit des gesamten Piezoaktors verhindert und damit die Haltbarkeit des Piezoaktors erhöht ist.

Bei einer ersten Ausführungsform sind in vorteilhafter Weise die Zentrierkörper Kegel, Kegelstümpfe oder ähnliche Körper, die am Kopf- und/oder Fußteil gehalten sind und in eine entsprechende Ausnehmung am zum Zwecke der Einspannung jeweils gegenüberliegen Teil eingreifen. Wenn beispielsweise am Kopfteil sowie am Fußteil ein Kegel vorhanden ist, so müsste am entsprechende Gegenstück, hier das Piezoelement, eine entsprechende Mulde bzw. Ausnehmung gefertigt werden, so dass das Kopf- und das Fußteil mit dem Piezoelement zentriert ist.

Bei einer anderen ebenfalls vorteilhaften Ausführungsform sind die Zentrierkörper Kugeln oder ähnliche Körper, die zum Zwecke der Einspannung in eine entsprechende Ausnehmung am Piezoelement eingreifen. Zum Fertigen der Ausnehmungen bzw. Mulden am Kopf- und/oder Fußteil kann man einen Formfräser, beispielsweise mit einem Kugelkopf, verwenden. Am Piezoelement kann beispielsweise beim Sintern der Keramik des Piezoelements das Kugelprofil berücksichtigt oder auch durch Nachfräsen oder Einschleifen hergestellt werden.

Um die zuvor erwähnte Zentrierung beizubehalten, besteht das Spannelement aus mindestens zwei Fäden, die mit ihren Enden jeweils am Kopf- und Fußteil derart befestigt sind, so dass sie das Piezoelement jeweils, vorzugsweise an gegenüberliegenden Seiten, einspannen.

Die Fäden, vorzugsweise Nylonfäden, sollten auch nach der Montage aus Stabilitätsgründen vorhanden bleiben.

Eine weitere vorteilhafte Variante der Erfindung besteht darin, das Kopf- und Fußteil über eine Wellfeder zusammen zu halten. Diese Wellfeder kann, beispielsweise durch Laserschweißen oder durch Kleben am Kopfteil sowie durch Einhängen am Fußteil, befestigt werden.

Die elektrische Kontaktierung des Piezoelements kann auf einfache Weise nach der Montage durch zwei Stifte erfolgen, die senkrecht nach oben stehen. Danach kann der zentrierte Piezoaktor im weiteren Montageprozess als Einheit behandelt werden.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ausführungsbeispiele des erfindungsgemäßen Piezoaktors werden anhand der Zeichnung erläutert. Es zeigen:
Figur 1 einen Schnitt und einen Querschnitt durch einen Piezoaktor zur Betätigung eines Einspritzinjektors zur Kraftstoffzumessung in einem Verbrennungsmotor mit zwei Wellfedern zur Einspannung eines Piezoelements und einer Fixierung des Piezoaktors mit zwei Kegeln;
Figur 2 einen Schnitt durch einen Piezoaktor, der in Abweichung von Figur 1 mit zwei Fäden zur Einspannung des Piezoelements versehen ist;
Figur 3 einen Schnitt durch einen Piezoaktor, der in Abweichung von Figur 1 mit zwei Kugeln zur Fixierung des Piezoelements versehen ist;
Figur 4 ein Detailbild des Kopf- und Fußteils des Piezoaktors mit Kegeln zur Fixierung;
Figur 5 ein Detailbild des Kopf- und Fußteils des Piezoaktors mit Kugeln zur Fixierung;
Figur 6 ein Detailbild Piezoelements mit Kegeln zur Fixierung und
Figur 7 ein Detailbild Piezoelements mit Kugeln zur Fixierung.

### Beschreibung der Ausführungsbeispiele

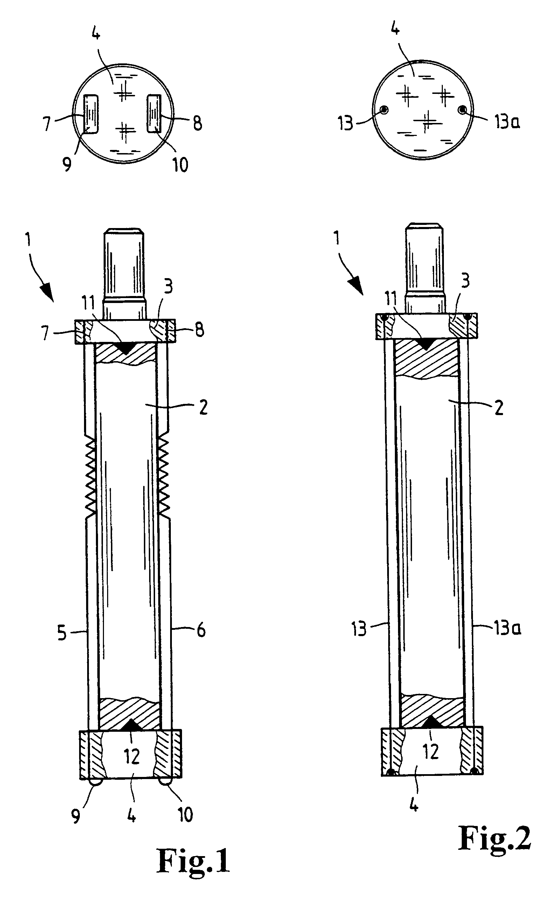

In der Darstellung nach Figur 1 ist ein Piezoaktor 1 mit einem Piezoelement 2 gezeigt, das zwischen einem Kopfteil 3 und einem Fußteil 4 eingespannt ist. Das Piezoelement 2 ist hier, wie an sich bekannt, aus einem Quarzmaterial mit einer geeigneten Kristallstruktur aufgebaut, so dass unter Ausnutzung des sogenannten Piezoeffekts bei Anlage einer äußeren elektrischen Spannung eine mechanische Reaktion des Piezoelements 2 in Richtung der Einspannung erfolgt.

Die Anordnung nach der Figur 1 wird mit Wellfedern 5 und 6 eingespannt, die oben am Kopfteil 3 an Stellen 7 und 8 verschweißt, vorzugsweise laserverschweißt, sind und unten an entsprechenden Vorrichtungen 9 und 10 eingehängt sind.

Zwischen dem Kopfteil 3 und dem Fußteil 4 ist das Piezoelement 2 mittels Zentrierkörper 11 und 12 mittig eingespannt. Die Zentrierkörper sind hier Kegel 11 und 12, die auf dem Kopf- und dem Fußteil 3,4 angebracht sind und in entsprechende Ausnehmungen oder Mulden im Piezoelement 2 eingreifen.

Bei der Anordnung nach Figur 2 wird die Einspannung des Piezoelements mit Nylonfäden 13 und 13a vorgenommen, die jeweils am Kopfteil 3 und am Fußteil 4 befestigt sind.

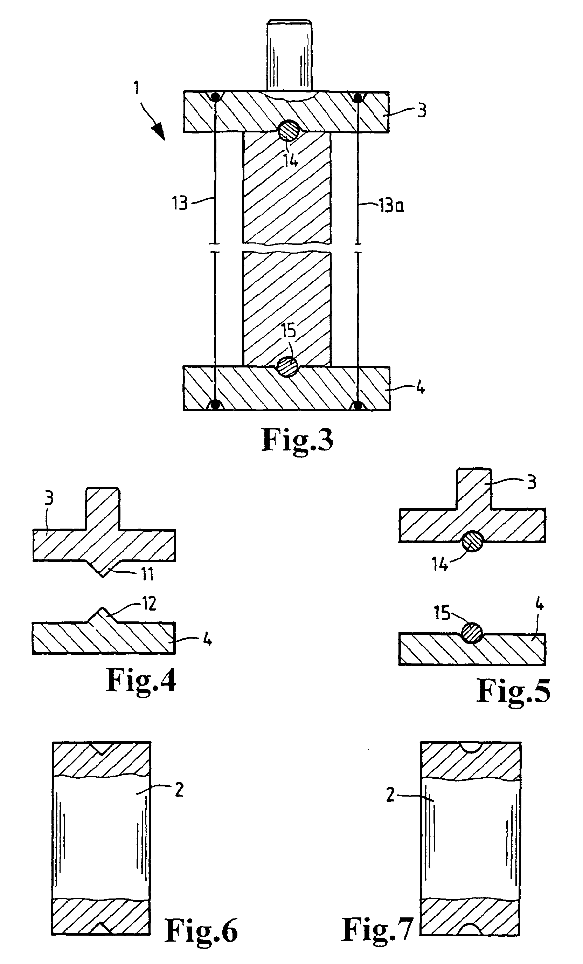

Ein alternatives Ausführungsbeispiel der Zentrierung mit Kugeln 14 und 15 zeigt Figur 3, bei der die Einspannung des Piezoelements beispielsweise auch mit Nylonfäden 13 und 13a vorgenommen werden können, die analog der Figur 2 jeweils am Kopfteil 3 und am Fußteil 4 befestigt sind. Die Kugeln 14 und 15 kommen hier bei der Montage des Piezoaktors 1 jeweils in entsprechenden Ausnehmungen im Kopfteil 3, im Fußteil 4 und im Piezoelement 2 zuliegen.

In Figur 4 ist ein Detailbild des Kopf- und Fußteils 3 und 4 des Piezoaktors 1 mit Kegeln 11 und 12 und in Figur 5 ist ein Detailbild des Kopf- und Fußteils 3 und 4 des Piezoaktors 1 mit Kugeln 14 und 15 gezeigt. In Figur 6 ist ein entsprechendes Detailbild des Piezoelements 2 für die Anordnung mit Kegeln 11 und 12 (Figur 4) und in Figur 7 ist ein entsprechendes Detailbild des Piezoelements 2 für eine Anordnung mit Kugeln 14 und 15 (Figur 5) zur Fixierung des Piezoelements 2 dargestellt.

## Patentansprüche

1. Piezoaktor zur Betätigung eines mechanischen Bauteils mit
- einem Kopfteil, mit einem Fußteil (3, 4) und mit einem dazwischen liegenden Piezoelement (2)
- mit einer Spannanordnung (5, 6; 13), die zwischen dem Kopf- und dem Fußteil (3, 4) zur Einspannung des Piezoelements (2) in Betätigungsrichtung angeordnet ist,
- mit mindestens einem Zentrierkörper (11,12; 14, 15), der ebenfalls zwischen dem Piezoelement (2) und dem Kopf- und/oder dem Fußteil (3, 4) eingespannt ist,
wobei jeweils ein Zentrierkörper (11, 12; 14,15) am Kopf- und Fußteil (3, 4) gehalten ist und in eine Ausnehmung der Keramik des Piezoelements (2) eingreift.

2. Piezoaktor nach Anspruch 1, **dadurch gekennzeichnet, dass**
- die Zentrierkörper jeweils ein Kegel (11,12), Kegelstumpf oder ähnlicher Körper sind, die am Kopf- beziehungsweise Fußteil (3, 4) gehalten sind und in eine entsprechende Ausnehmung am zum Zwecke der Einspannung jeweils gegenüberliegen Teil eingreifen.

3. Piezoaktor nach Anspruch 1, **dadurch gekennzeichnet, dass**
- die Zentrierkörper jeweils eine Kugel (14,15) oder ein ähnlicher Körper sind, die zum Zwecke der Einspannung in eine entsprechende Ausnehmung am Piezoelement (2) eingreifen.

4. Piezoaktor nach einem der vorhergehenden Ansprüche, **dadurch gekennzeichnet, dass**
- das Spannelement aus mindestens zwei Fäden (13,13a) besteht, die mit ihren Enden jeweils am Kopf- und Fußteil (3,4) derart befestigt sind, dass sie das Piezoelement (2) jeweils, vorzugsweise an gegenüberliegenden Seiten einspannen.

5. Piezoaktor nach Anspruch 4, **dadurch gekennzeichnet, dass**
- die Fäden Nylonfäden (13,13a) sind.

6. Piezoaktor nach einem der vorhergehenden Ansprüche, **dadurch gekennzeichnet, dass**
- das Spannelement aus mindestens zwei Wellfedern (5,6) besteht, die mit ihren Enden jeweils am Kopf- und Fußteil (3,4) derart befestigt sind, dass sie das Piezoelement (2) jeweils, vorzugsweise an gegenüberliegenden Seiten einspannen.

7. Piezoaktor nach Anspruch 6, **dadurch gekennzeichnet, dass**
- die Wellfedern (5,6) an einem Ende mit dem Kopf- oder Fußteil (3,4) verschweißt (7,8) sind und mit dem jeweils anderen Ende am Kopf- oder Fußteil (3,4) eingehängt (9,10) sind.

## Claims

1. Piezo actuator for operating a mechanical component, comprising
- a head part (3), comprising a foot part (4) and comprising a piezo element (2) which is situated between the said head part and foot part,
- comprising a clamping arrangement (5, 6; 13) which is arranged between the head part and the foot part (3, 4) for clamping-in the piezo element (2) in the operating direction,
- comprising at least one centring body (11, 12; 14, 15) which is likewise clamped-in between the piezo element (2) and the head part and/or the foot part (3, 4),
with a centring body (11, 12; 14, 15) being retained on the head part and foot part (3, 4) in each case and engaging in a recess in the ceramic of the piezo element (2).

2. Piezo actuator according to Claim 1, **characterized in that**
- the centring bodies are in each case a cone (11, 12), truncated cone or similar body and are retained on the head part or foot part (3, 4) and engage in a corresponding recess on the part which is respectively opposite for clamping purposes.

3. Piezo actuator according to Claim 1, **characterized in that**
- the centring bodies are in each case a cone (14, 15) or a similar body and engage in a corresponding recess in the piezo element (2) for clamping purposes.

4. Piezo actuator according to one of the preceding claims, **characterized in that**
- the clamping element comprises at least two threads (13, 13a) whose ends are in each case attached to the head part and foot part (3, 4) in such a way that they in each case clamp-in the piezo element (2), preferably on opposite sides.

5. Piezo actuator according to Claim 4, **characterized in that**
- the threads are nylon threads. (13, 13a).

6. Piezo actuator according to one of the preceding claims, **characterized in that**
- the clamping element comprises at least two corrugated springs (5, 6) whose ends are in each case attached to the head part and foot part (3, 4) in such a way that they in each case clamp-in the piezo element (2), preferably on opposite sides.

7. Piezo actuator according to Claim 6, **characterized in that**
- the corrugated springs (5, 6) are welded (7, 8) to the head part or foot part (3, 4) at one end and hooked (9, 10) onto the head part or foot part (3, 4) at the respectively other end.

## Revendications

1. Actionneur piézoélectrique pour commander un composant mécanique ayant
- une partie de tête avec une partie de pied (3, 4) et entre elles un élément piézoélectrique (2)
- un dispositif de tension (5, 6) ; (13) installé entre la partie de tête et la partie pied (3, 4) pour serrer l'élément piézoélectrique (2) dans la direction d'actionnement
- au moins un organe de centrage (11, 12) ; (14, 15) également serré entre l'élément piézoélectrique (2) et la partie de tête et/ou la partie de pied (3, 4),
selon lequel
un organe de centrage (11, 12) ; (14, 15) respectif est tenu à la partie de tête et la partie de pieds (3, 4) et pénètre dans une cavité de la matière céramique de l'élément piézoélectrique (2).

2. Actionneur piézoélectrique selon la revendication 1,
**caractérisé en ce que**
les organes de centrage sont chacun un cône (11, 12), un tronc de cône ou un organe analogue, tenus par la partie de tête ou la partie de pied (3, 4) et pénètrant dans une cavité correspondante pour serrer chaque fois la partie opposée.

3. Actionneur piézoélectrique selon la revendication 1,
**caractérisé en ce que**
les organes de centrage sont chaque fois une bille (14, 15) ou un organe analogue qui pénètre dans une cavité correspondante de l'élément piézoélectrique (2) pour le serrage.

4. Actionneur piézoélectrique selon l'une des revendications précédentes
**caractérisé en ce que**
- l'élément de serrage se compose d'au moins deux filtres (13, 13a) dont les extrémités sont fixées respectivement à la partie de tête et la partie de pied (3, 4), pour serrer les éléments piézo-électriques (2) chaque fois de préférence par les côtés opposés.

5. Actionneur piézoélectrique selon la revendication 4,
**caractérisé en ce que**
- les filtres sont des filtres en nylon (13, 13a).

6. Actionneur piézoélectrique selon l'une des revendications précédentes,
**caractérisé en ce que**
- l'élément de serrage est formé d'au moins deux ressorts ondulés (5, 6) dont les extrémités sont fixées respectivement à la pièce de tête et à la pièce de pied (3, 4) pour enserrer l'élément piézoélectrique (2) respectif de préférence par les côtés opposés.

7. Actionneur piézoélectrique selon la revendication 6,
**caractérisé en ce que**
les ressorts ondulés (5, 6) sont soudés par une extrémité à la partie de tête ou de pied (3, 4) et par l'autre extrémité respective ils sont accrochés à la partie de tête ou à la partie de pied (3, 4).
